# EUROPÄISCHE PATENTSCHRIFT

(11) **EP 2 717 340 B1**
(45) Veröffentlichungstag und Bekanntmachung des Hinweises auf die Patenterteilung: **01.07.2020**
(21) Anmeldenummer: 13187048.7
(22) Anmeldetag: 02.10.2013
(51) Int. Cl.: H01L 39/24

(54) **Halbzeugdraht für einen Nb3Sn-Supraleiterdraht**
Semi-finished wire for a Nb3Sn superconducting wire
Fil semi-fini pour un fil supraconducteur Nb3Sn

(30) Priorität: 05.10.2012 DE 102012218222
(43) Veröffentlichungstag der Anmeldung: 09.04.2014
(73) Patentinhaber: Bruker EAS GmbH, 63450 Hanau (DE)
(72) Erfinder: Schlenga, Klaus, 76149 Karlsruhe (DE)
(74) Vertreter: Kohler Schmid Möbus Patentanwälte

(56) Entgegenhaltungen:
- EP-A1- 0 119 553
- WO-A2-2006/038909
- DE-A1-102004 056 905

## Beschreibung

Die Erfindung betrifft einen Halbzeugdraht für einen Nb₃Sn-Supraleiterdraht, wobei der Halbzeugdraht umfasst
- eine Vielzahl von aneinander gepackten Nb-haltigen Elementen, wobei die Nb-haltigen Elemente jeweils einen Nb-haltigen Stab und eine diesen umgebende Cu-haltige Hülle aufweisen,
- eine Sn-haltige Struktur,
- und eine Cu-haltige Matrix, in der die Sn-haltige Struktur angeordnet ist und an und/oder in der die Nb-haltigen Elemente angeordnet sind.

Ein solcher Halbzeugdraht ist bekannt geworden durch die US 7,368,021 B2.

Nb₃Sn ist ein verbreitetes supraleitendes Material, insbesondere für die Fertigung von supraleitenden Magnetspulen. Nb₃Sn-Supraleiterdrähte erreichen im Vergleich zu anderen metallischen Tieftemperatur-Supraleitermaterialien (wie NbTi) deutlich höhere Stromdichten. Allerdings ist die Herstellung und Verarbeitung von Nb₃Sn-Supraleiterdrähten schwierig, da Nb₃Sn ein relativ sprödes Material ist und daher nicht (bzw. nur in minimalem Umfang) plastisch verformt werden kann.

Verformungsprozesse wie Drahtziehen werden daher an Halbzeug vorgenommen, in denen Nb oder Nb-haltige Filamente und Sn (legiert oder auch unlegiert) enthalten sind. Der Halbzeugdraht oder auch ein Bündel von Halbzeugdrähten wird weiterhin entsprechend der gewünschten Supraleiterdraht-Anordnung verlegt (etwa zu einer Spule gewickelt) und schließlich einer Reaktionswärmebehandlung unterzogen, während der im Halbzeugdraht enthaltenes Zinn (Sn) mit in den Filamenten enthaltenem Niob (Nb) zu Nb₃Sn reagiert. Nach der Reaktionswärmebehandlung wird der fertige Supraleiterdraht möglichst nicht mehr plastisch verformt.

Für die Herstellung von Nb₃Sn sind insbesondere die so genannte "Bronze-Route" (Bronze route) und die "Interne Zinn-Diffusion" (internal tin diffusion) bekannt geworden. Im Rahmen der Bronze-Route sind Nb-Filamente in eine Bronze-Matrix (Bronze: Legierung aus Cu und Sn) eingebettet, und bei der Reaktionswärmebehandlung reagiert das in der Bronze vorhandene Zinn zumindest teilweise mit dem Niob der Filamente. Die Bronze-Route ist in der Praxis einfach umzusetzen. Im Rahmen der Internen Zinn-Diffusion ist eine (bis zur finalen Wärmebehandlung) von Kupfer (Cu) separate Zinn-Quelle im Halbzeugdraht vorhanden, wodurch große Mengen an Zinn bereitgestellt werden können und damit große Querschnittsanteile an Nb₃Sn im fertigen Nb₃Sn-Supraleiterdraht eingerichtet werden können. Ein solcher Supraleiterdraht kann eine sehr hohe Stromtragfähigkeit erreichen. Allerdings ist die Handhabung des Halbzeugsdrahtes aufgrund des (im Vergleich zu Kupfer) recht weichen Zinns erschwert.

Aus der US 7,368,021 B2, insbesondere dortige Figur 3, ist ein Halbzeugdraht bekannt geworden, bei dem kupferumhüllte Nb-Stäbe dicht aneinander gepackt in einer Kupfermatrix angeordnet sind. Der Halbzeugdraht weist einen zentralen Zinn-Kern auf. Im Rahmen der Reaktionswärmebehandlung diffundiert Zinn aus dem Zinn-Kern durch die Kupfermatrix zu den Nb-Stäben.

Die Umhüllungen der Nb-Stäbe aus Kupfer stellen dabei Diffusionspfade für das Zinn auch zu den peripher gelegenen (nicht an die Kupfermatrix grenzenden) Nb-Stäben zur Verfügung, so dass auch diese Nb-Stäbe zu Nb₃Sn umgewandelt werden können. Dadurch kann ein Nb₃Sn-Draht mit hoher supraleitender Stromtragfähigkeit gefertigt werden.

Aus der EP 0 223 137 A1, insbesondere Fig. 4, ist ein Halbzeugdraht mit einem Sn-Kern, einer diesen umgebenden Bronze-Matrix und in der Bronze-Matrix verteilt angeordneten Nb-Filamenten bekannt geworden.

Die EP 0 119 553 A1 beschreibt einen Prozess zur Herstellung eines Supraleiters. In einer Matrix aus einem Oxid-Pulver, das mit einer leitfähigen Legierung wie Bronze oder Cupronickel dotiert ist, sind Multifilamentstäbe angeordnet. Die Multifilamentstäbe werden aus einer Bronzematrix, die Niobstäbe enthält, gebildet. Das Oxid-Pulver und die Multifilamentstäbe sind in einem Kupferrohr angeordnet.

Die DE 10 2004 056 905 A1 beschreibt einen Kernleiter für Multifilament-Supraleiter, wobei eine Nb- oder NbTi-Stange von einer Bronzematrix umhüllt ist. Bei einem Multifilament-Supraleiter mit Bronzematrix mit Sn-Gehalt über/gleich 17Gew%, ggf. auch mit 0,25-0,4 Gew% Ti, wurde ein gutes Umformverhalten beobachtet, wenn ein Duplexrohr aus CuSn13,5 oder CuSn13,5Ti innen und CuSn17 oder CuSn17Ti eingesetzt wird.

### Aufgabe der Erfindung

Der Erfindung liegt die Aufgabe zugrunde, einen Halbzeugdraht zur Fertigung eines Nb₃Sn-Supraleiterdrahts zur Verfügung zu stellen, mit dem eine weiter verbesserte supraleitende Stromtragfähigkeit erreichbar ist.

### Kurze Beschreibung der Erfindung

Diese Aufgabe wird gelöst durch einen Halbzeugdraht der eingangs genannten Art, der dadurch gekennzeichnet ist, dass die Cu-haltigen Hüllen der Nb-haltigen Elemente Sn-haltig sind, wobei der Gehalt an Sn in den Cu-haltigen Hüllen der Nb-haltigen Elemente maximal 4 Gew% beträgt.

Gemäß der Erfindung wird ein Halbzeugdraht (auch kurz Halbzeug genannt) bereitgestellt, bei dem bereits vor Beginn einer Reaktionswärmebehandlung Sn in den Cu-haltigen Hüllen der Nb-haltigen Elemente enthalten ist. Typischerweise wurden im Rahmen der Fertigung des Halbzeugdrahts Nb-Stäbe hierfür in Rohre, die Cu und erfindungsgemäß auch Sn enthalten (das sind die späteren Cu-haltigen Hüllen), eingeschoben, oder Nb-Stäbe und Cu-haltige Hüllen wurden gemeinsam stranggepresst, wobei die Cu-haltigen Hüllen bereits mit enthaltenem Sn stranggepresst wurden. Die so befüllten Rohre bzw. Strangpresslinge wurden dann als Nb-haltige Elemente bei der Fertigung des Halbzeugdrahts verbaut, insbesondere an oder in der Cu-haltigen Matrix angeordnet, und typischerweise in ein Cu-Hüllrohr eingefügt. Gegebenenfalls können ein oder mehrere Bündelungs- und Ziehschritte folgen. Der Halbzeugdraht kann schließlich in einer gewünschten Form verlegt werden, etwa zu einer Spule gewickelt werden, und anschließend einer Reaktionswärmebehandlung unterzogen werden.

Im Rahmen der späteren Reaktionswärmebehandlung des erfindungsgemäßen Halbzeugdrahtes diffundiert Sn vor allem von der Sn-haltigen Struktur durch die Cu-haltige Matrix und die Cu-haltigen Hüllen zu den Nb-Stäben, um Nb₃Sn zu bilden. Dadurch, dass die Cu-haltigen Hüllen der Nb-haltigen Elemente gemäß der Erfindung auch Sn enthalten, kann im Rahmen der Reaktionswärmebehandlung Sn deutlich schneller zu den Nb-Stäben gelangen als bei Cu-haltigen Hüllen, die zunächst kein Sn enthalten.

Die Nb-haltigen Elemente sind gemäß der Erfindung aneinander gepackt. Aneinander gepackt bedeutet, dass sich die Cu-haltigen Hüllen der Nb-haltigen Elemente gegenseitig berühren, bevorzugt flächig berühren. Die Nb-haltigen Elemente können in einer oder (seltener) in mehreren Gruppen aneinander gepackt angeordnet sein. Regelmäßig ist durch die aneinander gepackte Anordnung der Nb-haltigen Elemente eine Teilmenge der Nb-haltigen Elemente durch andere Nb-haltige Elemente von der Cu-haltigen Matrix getrennt (d.h. die Nb-haltigen Elemente dieser Teilmenge grenzen nicht an die Cu-haltige Matrix an).

Die Cu-haltigen Hüllen stellen die einzigen Pfade dar, durch die die nicht an die Cu-haltige Matrix grenzenden (etwa innen liegenden) Nb-haltigen Elemente Sn aus der Sn-haltigen Struktur erhalten können. Solange die Cu-haltigen Hüllen noch nicht mit Sn angereichert sind, ist eine Umwandlung der Nb-Stäbe von nicht an die Cu-haltige Matrix angrenzenden Nb-haltigen Elemente zu Nb₃Sn nicht möglich. Die Cu-haltigen Hüllen haben im Querschnitt (senkrecht zur Längserstreckung des Halbzeugdrahts) nur eine geringe Dicke, was eine Eindiffusion von Sn in die Hüllen zusätzlich erschweren kann.

Durch die erfindungsgemäß auch Sn-haltigen Cu-haltigen Hüllen sind diese Pfade bereits zu Beginn der Reaktionswärmebehandlung mit Sn angereichert und dadurch unmittelbar als Sn-Diffusionspfade nutzbar; eine Durchdringung mit Sn über die Cu-haltige Matrix braucht nicht abgewartet zu werden. Entsprechend kann die Bildung von Nb₃Sn sehr früh nach Beginn der Wärmebehandlung einsetzten und sehr schnell ablaufen, auch bei entfernt von der Cu-haltigen Matrix angeordneten (d.h. an die Cu-haltige Matrix nicht angrenzenden) Nb-haltigen Elementen.

Durch den frühen Beginn und die hohe Effizienz der Bildung von Nb₃Sn braucht die Reaktionswärmebehandlung nur relativ kurze Zeit. Entsprechend schreitet das Wachstum von Nb₃Sn-Körnern während der Reaktionswärmebehandlung nur wenig voran, so dass relativ kleine Nb₃Sn-Körner erhalten werden. Die kleinen Korngrößen gehen mit mehr Korngrenzfläche (bzw. einer höheren Korngrenzendichte) einher, die für die Fixierung von Flussschläuchen ("flux pinning") verantwortlich ist. Entsprechend kann im Rahmen der Erfindung eine sehr hohe kritische Flussdichte und eine sehr hohe kritische Stromstärke eines aus dem Halbzeugdraht hergestellten Supraleiterdrahts erreicht werden.

Durch den Einsatz einer Vielzahl von aneinander angrenzenden Nb-haltigen Elementen können grundsätzlich beliebige Anteile der Querschnittsfläche des Halbzeugdrahts mit Nb belegt werden; ebenso kann über die Sn-haltige Struktur auch der Anteil von Sn an der Querschnittsfläche grundsätzlich beliebig gewählt werden. Dadurch sind im fertigen Supraleiterdraht sehr hohe Flächenanteile von Nb₃Sn möglich, wodurch eine insgesamt hohe Stromtragfähigkeit des Supraleiterdrahts erreichbar ist. Man beachte jedoch, dass aus anwendungstechnischen Gründen ein gewisser Mindestanteil an Cu-Stabilisierung an der Querschnittsfläche, beispielsweise wenigstens 10%, bevorzugt 17- 25% Cu-Anteil, eingehalten wird. Die Cu-Stabilisierung ist von der reaktiven Fläche (bzw. dem reaktiven Bereich) üblicherweise durch eine Diffusionsbarriere getrennt.

Erfindungsgemäß ist vorgesehen, dass der Gehalt an Sn in den Cu-haltigen Hüllen der Nb-haltigen Elemente maximal 4 Gew% beträgt. Grundsätzlich gehen mit kleinerem Sn-Gehalt bessere mechanische Eigenschaften, insbesondere eine bessere Kaltverformbarkeit, der Cu-haltigen Hüllen einher. Bei einem Gehalt von erfindungsgemäß 4 Gew% Sn oder weniger sind Bronzematerialien guter Homogenität kommerziell erhältlich. Bei einem Sn-Gehalt von erfindungsgemäß 4 Gew% oder weniger wird außerdem eine für die meisten Ziehprozesse ausreichende Kaltumformbarkeit erzielt, bei 4 Gew% Sn um die 84%, und bei 2 Gew% Sn um 90%; diese Werte sind vergleichbar zur Kaltverformbarkeit von elementarem Kupfer. Bei ausreichend niedrigem Sn-Gehalt, wie im Rahmen der Erfindung mit 4 Gew% Sn oder weniger vorgesehen, kann in der Regel auf Zwischenglühungen bei der Herstellung eines Nb₃Sn-Supraleiterdrahts aus dem erfindungsgemäßen Halbzeugdraht vollständig verzichtet werden.

Typischerweise bestehen die Cu-haltigen Hüllen im Wesentlichen nur aus Cu und Sn, so dass andere Elemente insgesamt mit einem Gehalt von maximal 2 Gew%, bevorzugt maximal 1 Gew%, besonders bevorzugt maximal 0,5 Gew% enthalten sind. In der Regel liegt der Gehalt an Sn in den Cu-haltigen Hüllen zwischen 2 Gew% und 4 Gew%; in diesem Bereich ist noch eine sehr gute Kaltumformbarkeit gegeben, andererseits aber bereits genug Sn für eine deutliche beschleunigte Sn-Diffusion zu den Nb-Stäben bei der Reaktionswärmebehandlung vorhanden. Die Cu-haltige Matrix ist meist aus elementarem Kupfer gefertigt. Die Sn-haltige Struktur kann massiv oder auch pulverförmig sein; meist enthält sie elementares Sn und ist zentral im Halbzeugdraht angeordnet. Gew% steht für einen Anteil am Gewicht in Prozent.

### Bevorzugte Ausführungsformen der Erfindung

Bei einer vorteilhaften Ausführungsform des erfindungsgemäßen Halbzeugdrahtes beträgt der Gehalt an Sn in den Cu-haltigen Hüllen der Nb-haltigen Elemente wenigstens 0,5 Gew%, bevorzugt wenigstens 1 Gew%, besonders bevorzugt wenigstens 2 Gew%. Diese Zinngehalte haben sich in der Praxis bewährt und reichen aus, um eine deutliche Beschleunigung des Sn-Transports bereits in der Anfangsphase der Reaktionswärmebehandlung zu erzielen.

Bevorzugt ist weiterhin eine Ausführungsform, bei der die Cu-haltige Matrix weiterhin auch Sn-haltig ist, insbesondere wobei der Sn-Gehalt in der Cu-haltigen Matrix gleich hoch oder geringer ist als in den Cu-haltigen Hüllen. Durch eine Anreicherung auch der Cu-haltigen Matrix mit Sn kann die Diffusion von Sn von der Sn-haltigen Struktur zu den Nb-Stäben weiter beschleunigt werden. Die Cu-haltige Matrix kann unmittelbar (schon bei Beginn der Reaktionswärmebehandlung) als Sn-Diffusionspfad genutzt werden; es braucht keine Durchdringung der Cu-haltigen Matrix mit Sn aus der Sn-haltigen Struktur abgewartet werden. Auch dadurch kann die Behandlungszeit der Reaktionswärmebehandlung verkürzt und die Korngrenzendichte im Nb₃Sn hoch gehalten werden. Typischerweise enthält die Cu-haltige Matrix maximal 4 Gew% Sn, bevorzugt maximal 2 Gew% Sn, besonders bevorzugt maximal 1 Gew% Sn; dadurch kann ein gutes Kaltumformverhalten sichergestellt werden, was wegen des meist relativ hohen Anteils der Cu-haltigen Matrix an der Querschnittsfläche des Halbzeugdrahtes besonders wichtig ist. Alternativ kann auch die Cu-haltige Matrix Sn-frei oder quasi Sn-frei (mit einem Sn-Gehalt von 0,1 Gew% oder weniger) ausgebildet sein; dadurch kann das Kaltumformverhalten des Halbzeugdrahtes verbessert werden.

Bei einer vorteilhaften Ausführungsform sind die Nb-haltigen Elemente als Hexagonalelemente mit einem hexagonalen Querschnitt senkrecht zur Erstreckungsrichtung des Halbzeugs ausgebildet. Solche Hexagonalelemente sind gut zu handhaben und dicht aneinander zu packen, wobei sich flächige Kontakte ohne Zwischenräume ausbilden.

Ebenfalls vorteilhaft ist eine Ausführungsform, bei der die Sn-haltige Struktur zentral im Halbzeugdraht angeordnet ist, und die aneinander gepackten Nb-haltigen Elemente die Sn-haltige Struktur geschlossen ringförmig umgeben. Dadurch ist eine gleichmäßige Eindiffusion von Sn aus der Sn-haltigen Struktur in die Nb-haltigen Elemente möglich.

Eine bevorzugte Ausführungsform sieht vor, dass der Halbzeugdraht ein Cu-Hüllrohr und eine Diffusionsbarriere für Cu und Sn aufweist, wobei die Diffusionsbarriere für Cu und Sn innerhalb des Cu-Hüllrohrs ausgebildet ist, und dass die aneinander gepackten Nb-haltigen Elemente, die Sn-haltige Struktur und die Cu-haltige Matrix innerhalb der Diffusionsbarriere für Cu und Sn angeordnet sind, insbesondere wobei die Diffusionsbarriere aus Ta und/oder Nb ausgebildet ist. Die Diffusionsbarriere verhindert eine Verschlechterung der elektrischen Eigenschaften der Cu-Stabilisierung im späteren Supraleiterdraht.

Bei einer bevorzugten Weiterbildung dieser Ausführungsform sind Sn-haltige Zusatzstrukturen vorgesehen, die zwischen den aneinander gepackten Nb-haltigen Elementen und der Diffusionsbarriere für Cu und Sn angeordnet sind. Über die Sn-haltigen Zusatzstrukturen kann auch von der radial außen liegenden Seite Zinn in die Nb-haltigen Elemente eindiffundieren, insbesondere wenn die Sn-haltige Struktur zentral angeordnet ist und von den Nb-haltigen Elementen geschlossen ringförmig umgeben ist. Dadurch werden die Diffusionswege für Sn verkürzt, so dass auch dadurch eine schnellere Reaktionswärmebehandlung und entsprechend eine größere Korngrenzendichte erreichbar ist. Im Allgemeinen ist der Sn-Gehalt in den Sn-haltigen Zusatzstrukturen genauso hoch wie in den Cu-haltigen Hüllen der Nb-haltigen Elemente oder höher. Die Sn-haltigen Zusatzstrukturen können insbesondere (ähnlich wie die Sn-haltige Struktur) hochzinnhaltig ausgebildet sein und dann typischerweise wenigstens 20 Gew% Sn enthalten, bevorzugt wenigstens 50 Gew% Sn, besonders bevorzugt wenigstens 80 Gew% Sn, ganz besonders bevorzugt wenigstens 95 Gew% Sn. Die Sn-haltigen Zusatzstrukturen können insbesondere als Werkstoffverbund ausgebildet sein.

Bei einer vorteilhaften Weiterbildung dieser Ausführungsform sind die Sn-haltigen Zusatzstrukturen als an das Bündelbild angepasste Profilelemente ausgebildet. Typischerweise komplettieren die Profilelemente den Querschnitt des Halbzeugdrahtes zwischen der Außenkontur der aneinander gepackten Nb-haltigen Elemente ("Bündelbild") und der Diffusionsbarriere. Die Profilelemente können flächig an die aneinander gepackten Nb-haltigen Elemente angelegt werden, was die Handhabung erleichtert und Leerräume vermeidet. Bei hexagonalen Nb-haltigen Elementen können entsprechend angepasste Profilelemente eingesetzt werden.

Bevorzugt ist eine Ausführungsform, bei der die Sn-haltige Struktur wenigstens 20 Gew% Sn enthält, bevorzugt wenigstens 50 Gew% Sn, besonders bevorzugt wenigstens 80 Gew% Sn, ganz besonders bevorzugt wenigstens 95 Gew% Sn. Durch hohe Sn-Gehalte steht mehr Sn für eine Umwandlung von Nb zu Nb₃Sn zur Verfügung, insbesondere im Vergleich zur Bronze-Route. Entsprechend können auch größere Querschnittsflächen des späteren Supraleiterdrahts mit Nb₃Sn erfüllt werden. Die Sn-haltige Struktur kann insbesondere als Werkstoffverbund ausgebildet sein.

Bevorzugt ist auch eine Ausführungsform, gemäß der die Nb-haltigen Stäbe wenigstens 50 Gew% Nb enthalten, bevorzugt wenigstens 80% Gew% Nb, besonders bevorzugt 100 Gew% Nb. Durch hohe Nb-Gehalte steht mehr Nb für eine Umwandlung bei der Reaktion mit Sn, durch die Nb₃Sn gebildet wird, zur Verfügung. Entsprechend können wiederum auch größere Querschnittsflächen des späteren Supraleiterdrahts mit Nb₃Sn erfüllt werden.

In den Rahmen der vorliegenden Erfindung fällt auch ein Verfahren zur Herstellung eines Nb₃Sn-Supraleiterdrahts, das dadurch gekennzeichnet ist, dass ein oder mehrere, oben beschriebene, erfindungsgemäße Halbzeugdrähte einer Reaktionswärmebehandlung unterzogen werden, bei der Sn zumindest aus der Sn-haltigen Struktur und den Cu-haltigen Hüllen zu den Nb-haltigen Stäben diffundiert und zusammen mit dem Nb der Nb-haltigen Stäbe zu Nb₃Sn reagiert. Die Reaktionswärmebehandlung kann aufgrund des Gehalts von Sn in den Cu-haltigen Hüllen um die Nb-Stäbe (bereits vor der Erwärmung des Halbzeugdrahtes) besonders kurz gehalten werden, da ein erstmaliges Eindiffundieren von Sn in die Cu-haltigen Hüllen nicht abgewartet zu werden braucht. Typischerweise wird der Hauptteil der Reaktionswärmebehandlung bei einer Temperatur im Bereich 600-725°C durchgeführt.

Bei einer bevorzugten Variante des erfindungsgemäßen Verfahrens wird die Reaktionswärmebehandlung so geführt, dass die entstehenden Nb₃Sn-Körmer eine Korngrößenverteilung mit einem d50-Wert von 100nm oder weniger aufweisen, insbesondere wobei zumindest für die Durchmesser d aller entstehenden Nb₃Sn-Körner mit Ausnahme eines 10%Vol-Anteils der Nb₃Sn-Körner mit den kleinsten Durchmessern und eines 10%Vol-Anteils der Nb₃Sn-Körner mit den größten Durchmessern gilt 200nm ≥ d ≥ 30nm, bevorzugt 150nm ≥ d ≥ 30nm. Dadurch wird eine hohe Korngrenzendichte erreicht, wodurch die Fixierung von Flussschläuchen verstärkt wird. Entsprechend können besonders hohe kritische Stromdichten und hohe kritische Flussdichten (ein hohes kritisches "B-Feld") im Supraleiterdraht erreicht werden. Die Korngrößenverteilung bzw. das Kornwachstum kann insbesondere über die Dauer der Reaktionswärmebehandlung und auch über die Aufheiz- und Abkühlraten kontrolliert werden. Da aufgrund der Zusammensetzung des Halbzeugdrahtes relativ kurze Behandlungszeiten für eine vollständige oder nahezu vollständige Umwandung des im Halbzeugdraht enthaltenen Nb zu Nb₃Sn ausreichen, können die bezeichneten Korngrößenverteilungen bei üblichen Dimensionen von Nb₃Sn-Supraleiterdrähten ohne Weiteres erreicht werden. Typischerweise wird die Reaktionswärmebehandlung erfindungsgemäß so geführt, dass wenigstens 70%, bevorzugt wenigstens 90% und besonders bevorzugt wenigstens 95% des enthaltenen Nb zu Nb₃Sn umgewandelt werden; insbesondere kann die Behandlung auch abgebrochen werden, sobald ein gewünschter Anteil (typischerweise zwischen 90% und 99%) des enthaltenen Nb umgewandelt sind. Vol% steht für einen Anteil am Volumen in Prozent. Die Korngrößenverteilung kann über einen Querschliff bestimmt werden.

Besonders bevorzugt ist eine Verfahrensvariante, bei der der eine oder die mehreren Halbzeugdrähte vor der Reaktionswärmebehandlung einem Ziehprozess unterzogen werden. Ebenso bevorzugt ist eine Verfahrensvariante, bei der mehrere Halbzeugdrähte in ein Bündelungsrohr eingebracht werden und vor der Reaktionswärmebehandlung einem Ziehprozess unterzogen werden. Bei geeigneter Wahl des Sn-Gehalts in den Cu-haltigen Hüllen der Nb-haltigen Elemente des oder der Halbzeugdrähte beeinträchtigt das erfindungsgemäß Sn-haltige Material der Cu-haltigen Hüllen den Ziehprozess nicht merklich. Für Ziehprozesse hat sich der erfindungsgemäße Sn-Gehalt von 4 Gew% oder weniger besonders bewährt. Vor dem Ziehprozess können mehrere Halbzeugdrähte insbesondere rechteckig, hexagonal und/oder rund gebündelt werden. Gegebenenfalls können auch Mehrfach-Bündelungsschritte vor der Reaktionswärmebehandlung durchgeführt werden. Bevorzugt werden im Rahmen der Herstellung des Supraleiterdrahtes Zwischenglühungen am Halbzeugdraht vollständig vermieden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Darstellung einer ersten Ausführungsform eines erfindungsgemäßen Halbzeugdrahtes, im Querschnitt senkrecht zur Erstreckungsrichtung des Halbzeugdrahtes, mit ringförmig aneinander gepackten, hexagonalen Nb-haltigen Elementen;
- Fig. 2: eine schematische Darstellung einer zweiten Ausführungsform eines erfindungsgemäßen Halbzeugdrahtes, im Querschnitt senkrecht zur Erstreckungsrichtung des Halbzeugdrahtes, mit ringförmig aneinander gepackten, hexagonalen Nb-haltigen Elementen und Sn-haltigen Zusatzstrukturen;
- Fig. 3: einen schematische Darstellung einer dritten Ausführungsform eines erfindungsgemäßen Halbzeugdrahtes, im Querschnitt senkrecht zur Erstreckungsrichtung des Halbzeugdrahtes, mit mehreren Gruppen von aneinander gepackten, runden Nb-haltigen Elementen und Sn-haltigen Zusatzstrukturen;
- Fig. 4: eine schematische Abfolge einer Variante zur Herstellung eines Nb₃Sn-Supraleiterdrahts gemäß der Erfindung.

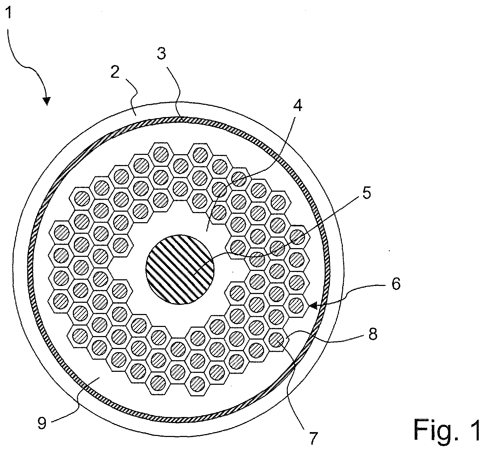

Die **Figur 1** zeigt in einem schematischen Querschnitt einen erfindungsgemäßen Halbzeugdrahtes 1 für einen Nb₃Sn-Supraleiterdraht, senkrecht zur Längserstreckung des Halbzeugdrahtes 1.

In einem Cu-Hüllrohr 2, welches an seiner Innenseite mit einer Diffusionsbarriere 3 hier aus Niob versehen ist, ist eine Cu-haltige Matrix 4 angeordnet. Im Zentrum der Cu-haltigen Matrix 4 ist hier eine Sn-haltige Struktur 5 angeordnet. Die Cu-haltige Struktur 5 kann beispielsweise ein Pulver aus elementarem Sn sein, welches in eine Bohrung in der Cu-haltigen Matrix 4 eingepresst ist, oder auch ein Stab aus einer hochzinnhaltigen Legierung.

Der Halbzeugdraht 1 umfasst weiterhin eine Vielzahl von Nb-haltigen Elementen 6, die aneinander gepackt (aneinander anliegend) angeordnet sind und hier insgesamt eine ringförmige Anordnung bilden. Radial nach innen grenzt die Anordnung der Nb-haltigen Elemente 6 an die Matrix 4 an; radial nach außen grenzt die Anordnung an eine Zusatzmatrix 9 an, die eine Abstützung zum Hüllrohr 2 vermittelt. Die Zusatzmatrix 9 besteht typischerweise aus elementarem Kupfer oder dem gleichen Material wie die Cu-haltige Matrix 4.

Die Nb-haltigen Elemente 6 sind hier im Querschnitt hexagonal ausgebildet. Jedes Nb-haltige Element 6 umfasst einen Nb-haltigen Stab 7 und eine Cu-haltige Hülle 8, die den Nb-haltigen Stab 7 im Querschnitt umgibt. Ein Nbhaltiger Stab 7 ist typischerweise aus elementarem Niob oder einer hochniobhaltigen Legierung gefertigt.

Gemäß der Erfindung ist in den Cu-haltigen Hüllen 8 der Nb-haltigen Elemente 6 auch Sn enthalten, hier zu einem Anteil von 2 Gew% (=Gewichts%). Zusätzlich kann vorgesehen sein, dass die Cu-haltige Matrix 4 ebenfalls Sn enthält, beispielsweise ebenfalls mit 2 Gew% Sn.

Wenn während einer Reaktionswärmebehandlung Sn aus der Sn-haltigen Struktur 5 zu den Nb-Stäben 7 diffundieren soll, müssen zunächst die Cu-haltige Matrix 4 und die Cu-haltigen Hüllen 8 vom Sn passiert werden. Wenn die Cu-haltigen Hüllen 8 und gegebenenfalls auch die Cu-haltige Matrix 4 bereits Sn enthalten, kann die Umwandlung des Nb in den Nb-Stäben 7 früher beginnen und schneller eine hohe Reaktionsgeschwindigkeit erreicht werden. Insbesondere ist durch die Anreicherung der Cu-haltigen Hüllen 8 der Zugang von Sn zu nicht an die Cu-haltige Matrix 4 grenzenden Nb-haltigen Elementen 6 verbessert.

Im Allgemeinen gelten für erfindungsgemäße Halbzeugdrähte folgende bevorzugte Bedingungen: Bevorzugt ist der Flächenanteil von Nb innerhalb und einschließlich der Diffusionsbarriere 3 in einem Bereich von 20% bis 70%, besonders bevorzugt 35% bis 60%. Weiterhin liegt das Flächenverhältnis von Nb zu Sn innerhalb und einschließlich der Diffusionsbarriere 3 bevorzugt in einem Bereich von 1,3 bis 2,5, besonders bevorzugt 1,6 bis 2. Für die Nb-haltigen Elemente ist jeweils ein Flächenanteilsverhältnis von Cu-haltiger Hülle zu Nb-Stab bevorzugt in einem Bereich von 0,1 bis 1,5, besonders bevorzugt 0,1 bis 0,5. Unmittelbar vor der Reaktionswärmebehandlung liegt der Durchmesser der Nb-Stäbe (Nb-Filamente) bevorzugt in einem Bereich zwischen 3 µm und 40 µm, besonders bevorzugt zwischen 3 µm und 30 µm, und die Diffusionsbarriere hat eine Dicke in einem Bereich von bevorzugt 5 µm bis 25 µm, besonders bevorzugt 10 µm bis 15 µm.

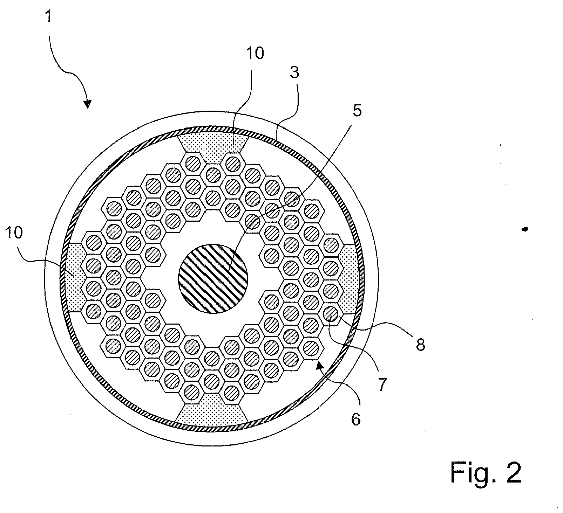

Die **Figur 2** zeigt eine zweite Ausführungsform eines erfindungsgemäßen Halbzeugdrahtes1, die weitgehend der Ausführungsform von Fig. 1 entspricht. Daher werden im Folgenden nur die wesentlichen Unterschiede dargestellt.

Der Halbzeugdraht 1 umfasst hier neben der zentralen Sn-haltigen Struktur 5 noch weitere Sn-Quellen, nämlich Sn-haltige Zusatzstrukturen 10. Diese Sn-haltigen Zusatzstrukturen 10 sind radial zwischen der ringförmigen Anordnung von Nb-haltigen Elementen 6 und der Diffusionsbarriere 3 angeordnet. In der gezeigten Ausführungsform sind die Sn-haltigen Zusatzstrukturen 10 aus einer zinnhaltigen Legierung, beispielsweise Pb-freies Weichlot gefertigt. Durch die Sn-haltigen Zusatzstrukturen 10 kann nicht nur von radial innen (über die Sn-haltige Struktur 5), sondern auch von radial außen Sn zu den Nb-haltigen Elementen 6 diffundieren. Dadurch können vor allem die Nb-Stäbe 7 von radial weiter außen liegenden Nb-haltigen Elementen 6 schneller zu Nb₃Sn umgewandelt werden.

In der gezeigten Ausführungsform sind die Sn-haltigen Zusatzstrukturen 10 als Profilelemente ausgebildet, die unmittelbar an die hexagonalen Nb-haltigen Elemente 6 angrenzen, so dass besonders kurze Diffusionswege von Sn aus den Sn-haltigen Zusatzstrukturen 10 zu den Nb-haltigen Elementen 6 gegeben sind. Da die Cu-haltigen Hüllen 8 bereits mit Sn angereichert sind, bestehen ausgehend von den Sn-haltigen Zusatzstrukturen 10 von Beginn einer Reaktionswärmebehandlung an mit Sn aufgefüllte Diffusionspfade für den Sn-Transport zu allen Nb-Stäben 7.

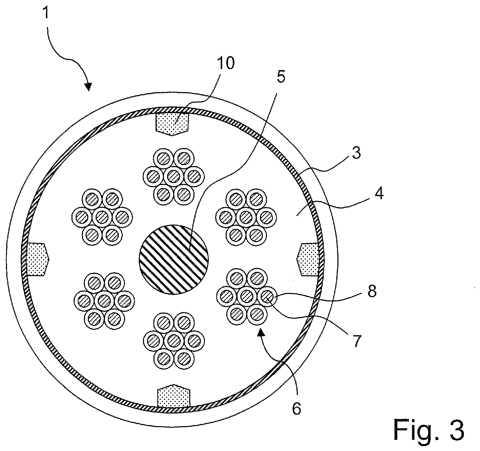

Die **Figur 3** zeigt eine dritte Ausführungsform eines erfindungsgemäßen Halbzeugdrahtes 1; es werden wiederum nur die wesentlichen Unterschiede zu den vorhergehenden Ausführungsformen erläutert.

Bei dieser Ausführungsform sind mehrere (hier sechs) Gruppen von Nb-haltigen Elementen 6 in die Cu-haltige Matrix 4 eingebettet, wobei innerhalb einer jeden Gruppe die Nb-haltigen Elemente 6 aneinander gepackt (aneinander anliegend) angeordnet sind. Die Nb-haltigen Elemente 6 weisen jeweils einen Nb-haltigen Stab 7 und eine diesen umgebende Cu-haltige Hülle 8 auf, wobei die Cu-haltige Hülle 8 hier einen runden Außenquerschnitt aufweist; alternativ wäre auch ein hexagonaler Außenquerschnitt (ähnlich wie in Fig. 1 und Fig. 2 gezeigt) möglich. Die Cu-haltigen Hüllen 8 der Nb-haltigen Elemente 6 sind gemäß der Erfindung Sn-haltig.

Als Sn-Quellen stehen neben der Sn-haltigen Struktur 5 im Zentrum des Halbzeugdrahtes 1 auch mehrere Sn-haltige Zusatzstrukturen 10 zur Verfügung. Die Sn-haltigen Zusatzstrukturen 10 liegen an der Cu-haltigen Matrix 4 an, so dass kein direkter Kontakt zwischen den Sn-haltigen Zusatzstrukturen 10 und den Nb-haltigen Elementen 6 besteht. Dadurch ist das Zusammenfügen des Halbzeugdrahts 1 erleichtert. Die Sn-haltigen Zusatzstrukturen 10 sind wiederum radial zwischen den Nb-haltigen Elementen 6 und der Diffusionsbarriere 3 angeordnet, um auch die Nb-Stäbe 7 der radial weiter außen liegenden Nb-haltigen Elemente 6 gut mit Sn versorgen zu können.

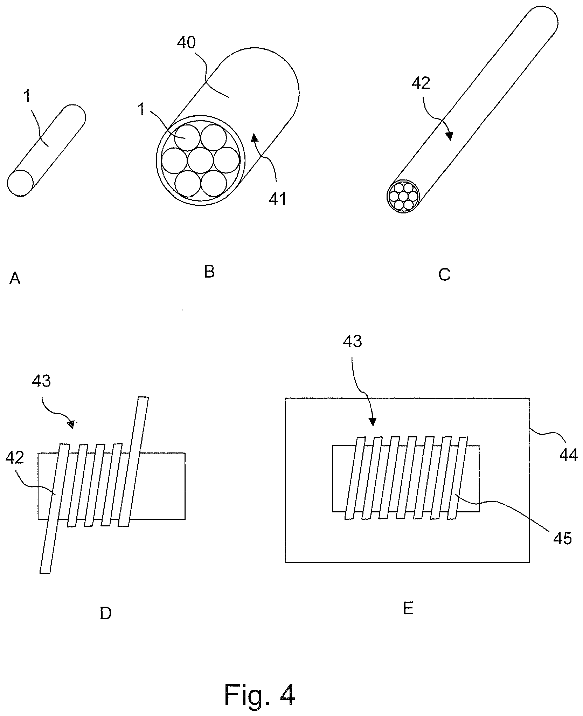

Die Figur 4 illustriert die Herstellung eines Nb₃Sn-Supraleiterdrahts ausgehend von einem Halbzeugdraht 1, wie er beispielsweise in den Figuren 1, 2 und 3 dargestellt ist.

In der in Fig. 4 vorgestellten Variante werden zunächst einige erfindungsgemäße Halbzeugdrähte 1, in denen die Cu-haltigen Hüllen um die Nb-Stäbe erfindungsgemäß mit Sn angereichert sind (vgl. Teilabbildung A), in einem Bündelrohr (Mantelrohr) 40 (typischerweise aus Cu) zu einem Bündel 41 gebündelt (vgl. Teilabbildung B). Anschließend wird dieses Bündel 41 einem Ziehprozess unterzogen, bei dem der Durchmesser des Bündels 41 schrumpft, aber die Länge des Bündels 41 zunimmt (vgl. Teilabbildung C). Bei geeignetem Gehalt an Sn in den Cu-haltigen Hüllen oder auch in der Cu-haltigen Matrix (bevorzugt jeweils zwischen 2 und 5 Gew% Sn) können die im Bündel 41 enthaltenen Halbzeugdrähte 1 problemlos an der mit dem Ziehprozess einhergehenden plastischen Verformung (Kaltumformung) teilnehmen. Falls gewünscht können auch mehrere Bündel- und Ziehprozesse hintereinander geschachtelt stattfinden.

Mit dem solchermaßen gezogenen Bündel, das auch als Bündeldraht 42 bezeichnet werden kann, kann die gewünschte Supraleiteranwendung vorbereitet werden. Hierbei wird der Bündeldraht 42 in derjenigen Geometrie verlegt, in der ein Supraleiterdraht benötigt wird. In der illustrierten Variante wird eine Solenoidspule 43 mit dem Bündeldraht 42 gewickelt (vgl. Teilabbildung D).

Schließlich wird die vorbereitete Supraleiteranwendung, hier die gewickelte Solenoidspule 43, einer Reaktionswärmebehandlung unterzogen; im illustrierten Beispiel ist hierzu die Solenoidspule 43 in einem Ofen 44 angeordnet worden (vgl. Teilabbildung E). Während der Reaktionswärmebehandlung diffundiert Sn insbesondere aus der Sn-haltigen Struktur zu den Nb-Stäben der Halbzeugdrähte, wobei aufgrund der bereits mit Sn angereicherten Cu-haltigen Hüllen (und gegebenenfalls auch einer mit Sn angereicherten Cu-haltigen Matrix und/oder Sn-haltiger Zusatzstrukturen) die Behandlungszeit der Reaktionswärmebehandlung relativ kurz gewählt werden kann. Dadurch kann aus dem Bündeldraht ein Nb₃Sn-Supraleiterdraht 45 mit besonders kleinen Nb₃Sn-Körnern erhalten werden, der eine besonders hohe supraleitende Stromtragfähigkeit aufweist.

Gemäß dem erfindungsgemäßen Verfahren hergestellte Nb₃Sn-Supraleiterdrähte können beispielsweise für supraleitende Magnete in der Kernspinresonanz (NMR), insbesondere für Höchstfeld-NMR-Magnete (mit B₀≥10 Tesla, bevorzugt B₀≥15 Tesla), oder auch für supraleitende Dipolmagnete, wie sie für Teilchenbeschleuniger oder Fusionskraftwerke benötigt werden, eingesetzt werden.

## Patentansprüche

1. Halbzeugdraht (1) für einen Nb₃Sn-Supraleiterdraht (45),
wobei der Halbzeugdraht (1) umfasst
- eine Vielzahl von aneinander gepackten Nb-haltigen Elementen (6), wobei die Nb-haltigen Elemente (6) jeweils einen Nb-haltigen Stab (7) und eine diesen umgebende Cu-haltige Hülle (8) aufweisen,
- eine Sn-haltige Struktur (5),
- und eine Cu-haltige Matrix (4), in der die Sn-haltige Struktur (5) angeordnet ist und an und/oder in der die Nb-haltigen Elemente (6) angeordnet sind,
**dadurch gekennzeichnet,**
**dass** die Cu-haltigen Hüllen (8) der Nb-haltigen Elemente (6) Sn-haltig sind, wobei der Gehalt an Sn in den Cu-haltigen Hüllen (8) der Nb-haltigen Elemente (6) maximal 4 Gew% beträgt.

2. Halbzeugdraht (1) nach Anspruch 1, **dadurch gekennzeichnet, dass** der Gehalt an Sn in den Cu-haltigen Hüllen (8) der Nb-haltigen Elemente (6) wenigstens 0,5 Gew%, bevorzugt wenigstens 1 Gew%, besonders bevorzugt wenigstens 2 Gew% beträgt.

3. Halbzeugdraht (1) nach einem der vorhergehenden Ansprüche, **dadurch gekennzeichnet, dass** die Cu-haltige Matrix (4) auch Sn-haltig ist, insbesondere wobei der Sn-Gehalt in der Cu-haltigen Matrix (4) gleich hoch oder geringer ist als in den Cu-haltigen Hüllen (8).

4. Halbzeugdraht (1) nach einem der vorhergehenden Ansprüche, **dadurch gekennzeichnet, dass** die Nb-haltigen Elemente (6) als Hexagonalelemente mit einem hexagonalen Querschnitt senkrecht zur Erstreckungsrichtung des Halbzeugdrahts (1) ausgebildet sind.

5. Halbzeugdraht (1) nach einem der vorhergehenden Ansprüche, **dadurch gekennzeichnet, dass** die Sn-haltige Struktur (5) zentral im Halbzeugdraht (1) angeordnet ist, und die aneinander gepackten Nb-haltigen Elemente (6) die Sn-haltige Struktur (5) geschlossen ringförmig umgeben.

6. Halbzeugdraht (1) nach einem der vorhergehenden Ansprüche, **dadurch gekennzeichnet, dass** der Halbzeugdraht (1) ein Cu-Hüllrohr (2) und eine Diffusionsbarriere (3) für Cu und Sn aufweist, wobei die Diffusionsbarriere (3) für Cu und Sn innerhalb des Cu-Hüllrohrs (2) ausgebildet ist,
und dass die aneinander gepackten Nb-haltigen Elemente (6), die Sn-haltige Struktur (5) und die Cu-haltige Matrix (4) innerhalb der Diffusionsbarriere (3) für Cu und Sn angeordnet sind,
insbesondere wobei die Diffusionsbarriere (3) aus Ta und/oder Nb ausgebildet ist.

7. Halbzeugdraht (1) nach Anspruch 6, **dadurch gekennzeichnet, dass** Sn-haltige Zusatzstrukturen (10) vorgesehen sind, die zwischen den aneinander gepackten Nb-haltigen Elementen (6) und der Diffusionsbarriere (3) für Cu und Sn angeordnet sind.

8. Halbzeugdraht (1) nach Anspruch 7, **dadurch gekennzeichnet, dass** die Sn-haltigen Zusatzstrukturen (10) als an das Bündelbild angepasste Profilelemente ausgebildet sind, so dass die Profilelemente den Querschnitt des Halbzeugdrahtes (1) zwischen der Außenkontur der aneinander gepackten Nb-haltigen Elemente (6) und der Diffusionsbarriere (3) komplettieren, wobei die Profilelemente flächig an die aneinander gepackten Nb-haltigen Elemente (6) angelegt werden.

9. Halbzeugdraht (1) nach einem der vorhergehenden Ansprüche, **dadurch gekennzeichnet, dass** die Sn-haltige Struktur (5) wenigstens 20 Gew% Sn enthält, bevorzugt wenigstens 50 Gew% Sn, besonders bevorzugt wenigstens 80 Gew% Sn, ganz besonders bevorzugt wenigstens 95 Gew% Sn.

10. Halbzeugdraht (1) nach einem der vorhergehenden Ansprüche, **dadurch gekennzeichnet, dass** die Nb-haltigen Stäbe (7) wenigstens 50 Gew% Nb enthalten, bevorzugt wenigstens 80% Gew% Nb, besonders bevorzugt 100 Gew% Nb.

11. Halbzeugdraht (1) nach einem der vorhergehenden Ansprüche, **dadurch gekennzeichnet, dass** sich die aneinander gepackten Nb-haltigen Elemente (6) mit ihren Cu-haltigen Hüllen (8) gegenseitig berühren.

12. Verfahren zur Herstellung eines Nb₃Sn-Supraleiterdrahts (45), **dadurch gekennzeichnet, dass** ein oder mehrere Halbzeugdrähte (1) nach einem der vorhergehenden Ansprüche einer Reaktionswärmebehandlung unterzogen werden, bei der Sn zumindest aus der Sn-haltigen Struktur (5) und den Cu-haltigen Hüllen (8) zu den Nb-haltigen Stäben (7) diffundiert und zusammen mit dem Nb der Nb-haltigen Stäbe (7) zu Nb₃Sn reagiert.

13. Verfahren nach Anspruch 12, **dadurch gekennzeichnet, dass** die Reaktionswärmebehandlung so geführt wird, dass die entstehenden Nb₃Sn-Körmer eine Korngrößenverteilung mit einem d50-Wert von 100nm oder weniger aufweisen,
insbesondere wobei zumindest für die Durchmesser d aller entstehenden Nb₃Sn-Körner mit Ausnahme eines 10 Vol%-Anteils der Nb₃Sn-Körner mit den kleinsten Durchmessern und eines 10 Vol%-Anteils der Nb₃Sn-Körner mit den größten Durchmessern gilt 200nm ≥ d ≥ 30nm, bevorzugt 150nm ≥ d ≥ 30nm.

14. Verfahren nach Anspruch 12 oder 13, **dadurch gekennzeichnet, dass** der eine oder die mehreren Halbzeugdrähte (1) vor der Reaktionswärmebehandlung einem Ziehprozess unterzogen werden.

15. Verfahren nach einem der Ansprüche 12 bis 14, **dadurch gekennzeichnet, dass** mehrere Halbzeugdrähte (1) in ein Bündelungsrohr (40) eingebracht werden und vor der Reaktionswärmebehandlung einem Ziehprozess unterzogen werden.

## Claims

1. Semi-finished wire (1) for an Nb₃Sn superconducting wire (45),
wherein the semi-finished wire (1) comprises
- a multiplicity of elements (6) containing Nb which are packed against each other, wherein the elements (6) containing Nb each have a rod (7) containing Nb and an enclosure (8) containing Cu surrounding the rod,
- a structure (5) containing Sn,
- and a matrix (4) containing Cu, in which the structure (5) containing Sn is disposed and on and/or in which the elements (6) containing Nb are disposed,
**characterized in that**
the enclosures (8) containing Cu of the elements (6) containing Nb contain Sn, wherein the content of Sn in the enclosures (8) containing Cu of the elements (6) containing Nb is maximally 4 % by weight.

2. Semi-finished wire (1) according to claim 1, **characterized in that** the content of Sn in the enclosures (8) containing Cu of the elements (6) containing Nb is at least 0.5 % by weight, preferably at least 1 % by weight, especially preferably at least 2 % by weight.

3. Semi-finished wire (1) according to any one of the preceding claims, **characterized in that** the matrix (4) containing Cu also contains Sn, in particular wherein the Sn content in the matrix (4) containing Cu is equal to or less than that of the enclosures (8) containing Cu.

4. Semi-finished wire (1) according to any one of the preceding claims, **characterized in that** the elements (6) containing Nb are constituted as hexagonal elements with a hexagonal cross-section perpendicular to the direction of extension of the semi-finished wire (1).

5. Semi-finished wire (1) according to any one of the preceding claims, **characterized in that** the structure (5) containing Sn is disposed centrally in the semi-finished wire (1), and that the elements (6) containing Nb which are packed against each other surround the structure (5) containing Sn to form a closed ring.

6. Semi-finished wire (1) according to any one of the preceding claims, **characterized in that** the semi-finished wire (1) has a Cu cladding tube (2) and a diffusion barrier (3) for Cu and Sn, wherein the diffusion barrier (3) for Cu and Sn is constituted inside the Cu cladding tube (2),
and that the elements (6) containing Nb which are packed against each other, the structure (5) containing Sn and the matrix (4) containing Cu are arranged inside the diffusion barrier (3) for Cu and Sn,
in particular wherein the diffusion barrier (3) is constituted from Ta and/or Nb.

7. Semi-finished wire (1) according to claim 6, **characterized in that** additional structures (10) containing Sn are provided, which are disposed between the elements (6) containing Nb which are packed against each other and the diffusion barrier (3) for Cu and Sn.

8. Semi-finished wire (1) according to claim 7, **characterized in that** the additional structures (10) containing Sn are constituted as profile elements adapted to the bundle configuration, such that the profile elements complete the cross-section of the semi-finished wire (1) between the outer contour of the elements (6) containing Nb which are packed against each other and the diffusion barrier (3), wherein the profile elements are disposed flatly against the elements (6) containing Nb which are packed against each other.

9. Semi-finished wire (1) according to any one of the preceding claims, **characterized in that** the structure (5) containing Sn contains at least 20 % by weight of Sn, preferably at least 50 % by weight of Sn, especially preferably at least 80 % by weight of Sn, highly preferably at least 95 % by weight of Sn.

10. Semi-finished wire (1) according to any one of the preceding claims, **characterized in that** the rods (7) containing Nb contain at least 50 % by weight of Nb, preferably at least 80 % by weight of Nb, especially preferably 100 % by weight of Nb.

11. Semi-finished wire (1) according to any one of the preceding claims, **characterized in that** the elements (6) containing Nb which are packed against each other contact each other with their enclosures (8) containing Cu.

12. Method for manufacturing an Nb₃Sn superconducting wire (45), **characterized in that** one or multiple semi-finished wires (1) according to any one of the preceding claims are subjected to reaction heat treatment, in which Sn diffuses at least out of the structure (5) containing Sn and the enclosures (8) containing Cu to the rods (7) containing Nb, and reacts with the Nb of the rods (7) containing Nb to form Nb₃Sn.

13. Method according to claim 12, **characterized in that** the reaction heat treatment is performed in such a way that the resulting Nb₃Sn grains have a grain size distribution with a d50 value of 100nm or less,
in particular wherein at least for the diameters d of all resulting Nb₃Sn grains, with the exception of a proportion of 10 % by volume of the Nb₃Sn grains having the smallest diameters and a proportion of 10 % by volume of the Nb₃Sn grains having the largest diameters, 200nm ≥ d ≥ 30nm, preferably 150nm ≥ d ≥ 30nm.

14. Method according to claim 12 or 13, **characterized in that** the one or the multiple of the semi-finished wires (1) are subjected to a drawing process before the reaction heat treatment.

15. Method according to any one of the claims 12 to 14, **characterized in that** multiple semi-finished wires (1) are inserted into a bundling tube (40) and are subjected to a drawing process before the reaction heat treatment.

## Revendications

1. Fil semi-fini (1) pour un fil supraconducteur en Nb₃Sn (45),
le fil semi-fini (1) comprenant
- une pluralité d'éléments contenant du Nb (6) serrés les uns contre les autres, les éléments contenant du Nb (6) présentant chacun une barre contenant du Nb (7) et une gaine contenant du Cu (8) qui l'entoure,
- une structure contenant du Sn (5),
- et une matrice contenant du Cu (4) dans laquelle la structure contenant du Sn (5) est disposée et sur et/ou dans laquelle les éléments contenant du Nb (6) sont disposés,
**caractérisé en ce**
**que** les gaines contenant du Cu (8) des éléments contenant du Nb (6) contiennent du Sn, la teneur en Sn des gaines contenant du Cu (8) des éléments contenant du Nb (6) étant au maximum de 4 % en poids.

2. Fil semi-fini (1) selon la revendication 1, **caractérisé en ce que** la teneur en Sn des gaines contenant du Cu (8) des éléments contenant du Nb (6) est d'au moins 0,5 % en poids, de préférence d'au moins 1 % en poids, particulièrement de préférence d'au moins 2 % en poids.

3. Fil semi-fini (1) selon l'une des revendications précédentes, **caractérisé en ce que** la matrice contenant du Cu (4) contient également du Sn, en particulier la teneur en Sn de la matrice contenant du Cu (4) étant égale ou inférieure à celle des gaines contenant du Cu (8).

4. Fil semi-fini (1) selon l'une des revendications précédentes, **caractérisé en ce que** les éléments contenant du Nb (6) sont réalisés sous la forme d'éléments hexagonaux ayant une section transversale hexagonale perpendiculairement à la direction d'extension du fil semi-fini (1).

5. Fil semi-fini (1) selon l'une des revendications précédentes, **caractérisé en ce que** la structure contenant du Sn (5) est disposée au centre du fil semi-fini (1) et les éléments contenant du Nb (6) serrés les uns contre les autres entourent la structure contenant du Sn (5) en forme d'anneau fermé.

6. Fil semi-fini (1) selon l'une des revendications précédentes, **caractérisé en ce que** le fil semi-fini (1) présente un fourreau en Cu (2) et une barrière de diffusion pour le Cu et le Sn (3), la barrière de diffusion pour le Cu et le Sn (3) étant formée à l'intérieur du fourreau en Cu (2),
et que les éléments contenant du Nb (6) serrés les uns contre les autres, la structure contenant du Sn (5) et la matrice contenant du Cu (4) sont disposés à l'intérieur de la barrière de diffusion pour le Cu et le Sn (3),
la barrière de diffusion (3) étant en particulier formée de Ta et/ou de Nb.

7. Fil semi-fini (1) selon la revendication 6, **caractérisé en ce que** des structures supplémentaires contenant du Sn (10) sont prévues, qui sont disposées entre les éléments contenant du Nb (6) serrés les uns contre les autres et la barrière de diffusion pour le Cu et le Sn (3).

8. Fil semi-fini (1) selon la revendication 7, **caractérisé en ce que** les structures supplémentaires contenant du Sn (10) sont réalisées sous la forme d'éléments profilés adaptés au motif de faisceau, de telle sorte que les éléments profilés complètent la section transversale du fil semi-fini (1) entre le contour extérieur des éléments contenant du Nb (6) serrés les uns contre les autres et la barrière de diffusion (3), les éléments profilés étant appliqués à plat contre les éléments contenant du Nb (6) serrés les uns contre les autres.

9. Fil semi-fini (1) selon l'une des revendications précédentes, **caractérisé en ce que** la structure contenant du Sn (5) contient au moins 20 % en poids de Sn, de préférence au moins 50 % en poids de Sn, particulièrement de préférence au moins 80 % en poids de Sn, tout particulièrement de préférence au moins 95 % en poids de Sn.

10. Fil semi-fini (1) selon l'une des revendications précédentes, **caractérisé en ce que** les barres contenant du Nb (7) contiennent au moins 50 % en poids de Nb, de préférence au moins 80 % en poids de Nb, particulièrement de préférence 100 % en poids de Nb.

11. Fil semi-fini (1) selon l'une des revendications précédentes, **caractérisé en ce que** les éléments contenant du Nb (6) serrés les uns contre les autres sont en contact les uns avec les autres par leurs gaines contenant du Cu (8).

12. Procédé de fabrication d'un fil supraconducteur en Nb₃Sn (45), **caractérisé en ce qu'**un ou plusieurs fils semi-finis (1) selon l'une des revendications précédentes sont soumis à un traitement thermique de réaction dans lequel du Sn provenant au moins de la structure contenant du Sn (5) et des gaines contenant du Cu (8) diffuse dans les barres contenant du Nb (7) et réagit avec le Nb des barres contenant du Nb (7) pour former du Nb₃Sn.

13. Procédé selon la revendication 12, **caractérisé en ce que** le traitement thermique de réaction est effectué de telle sorte que les grains de Nb₃Sn formés présentent une distribution granulométrique avec une valeur d50 de 100 nm ou moins,
en particulier dans lequel il s'applique 200 nm ≥ d ≥ 30 nm, de préférence 150 nm ≥ d ≥ 30 nm, au moins pour les diamètres d de tous les grains de Nb₃Sn formés à l'exception d'une proportion de 10 % en volume des grains de Nb₃Sn ayant les plus petits diamètres et d'une proportion de 10 % en volume des grains de Nb₃Sn ayant les plus grands diamètres.

14. Procédé selon la revendication 12 ou 13, **caractérisé en ce que** lesdits un ou plusieurs fils semi-finis (1) sont soumis à un processus d'étirage avant le traitement thermique de réaction.

15. Procédé selon l'une des revendications 12 à 14, **caractérisé en ce que** plusieurs fils semi-finis (1) sont introduits dans un tube de mise en faisceau (40) et soumis à un processus d'étirage avant le traitement thermique de réaction.
